# EUROPEAN PATENT SPECIFICATION

(11) **EP 2 054 771 B1**
(45) Date of publication and mention of the grant of the patent: **30.08.2017**
(21) Application number: 07793822.3
(22) Date of filing: 13.07.2007
(51) Int. Cl.: G03F 7/20

(54) **LITHOGRAPHY SYSTEM, METHOD OF HEAT DISSIPATION AND FRAME**
LITHOGRAPHIESYSTEM, WÄRMEABLEITVERFAHREN UND RAHMEN
SYSTÈME LITHOGRAPHIQUE, PROCÉDÉ DE DISSIPATION THERMIQUE ET STRUCTURE

(30) Priority: 28.07.2006 US 833865 P; 28.07.2006 NL 1032251
(43) Date of publication of application: 06.05.2009
(73) Proprietor: Mapper Lithography IP B.V., 2628 XK Delft (NL)
(72) Inventor: DANSBERG, Michel, Pieter, NL-2628 XK Delft (NL); KRUIT, Pieter, 2628 XK Delft (NL); WIELAND, Marco, Jan-Jaco, NL-2628 XK Delft (NL)
(74) Representative: Peters, Sebastian Martinus
(86) International application number: PCT/NL2007/000181
(87) International publication number: WO 2008/013443

(56) References cited:
- EP-A- 0 076 079
- EP-A- 0 484 179
- WO-A-02/21579
- JP-A- 7 226 371
- US-A- 4 911 232
- US-A1- 2005 128 448

## Description

The present invention relates to a lithography system for projecting an image pattern on to a target surface such as a wafer.

Such systems are generally known, e.g. in the form of a mask writer or in the form of a lithography application as in WO 2004038509. In the example presented by the latter system, the target to be patterned is subjected to incidence of photons or charged particles such as ions and electrons. Due to the energy load of such particles or photons, inherent to the manner of extracting or emitting the same, the target is at least locally heated. Such heating, in accordance with an insight developed as part of the invention, becomes problematic when expansion of the target under influence by its processing exceeds a predefined value. In general it was observed that heating becomes problematic with the ever continuing, contemporary development towards high throughput.

As a general idea underlying the present invention it is understood that heat development and its removal from the target to be processed will be problematic in all sort of lithography. This may e.g. be due to ever decreasing size of nodes and/or to tighter overlay prescription, and is also problematic in contemporary emerging, vacuum types of lithography.

Thus, with contemporary development in demand of accuracy and miniaturization, all type of lithography deal with the problem of heat inducement, e.g. mask based such as conventional lithography or mask based electron beam lithography such as Scalpel. Such heat inducement may lead to instability of target temperature, in fact instability in expansion of the target such as a wafer. In this respect it is remarked that irrespective of the manner of transferring a pattern on to a target, accuracy, especially in relation to the aspect of overlay in wafers, becomes more and more critical with increasing resolution of such patterns. An important issue in controlling the accuracy of patterning is controlling the temperature stability of the target during exposure. It is therefore an important aspect of both conventional or other mask based lithography, and maskless lithography to realize a swift and adequate manner of heat dissipation from a wafer that is being processed.

Yet another circumstance urging lithography to find solutions related to heat removal from wafers in progress is found at current methods of lithography that will, with increasing demands in specifications, shift from present atmospheric processing of targets towards vacuum processing thereof, such as may be expected at EUV processing of targets. Such a transition will imply that currently known methods of heat transfer can no longer be applied, and that new methods of heat transfer are required. In general it can be stated that with inducement of heat to a wafer or kind like target, the target expands, which results in a difference between the actual and expected position and dimension of e.g. a die on said target, which will result in an error of the exposure pattern on the target.

It is remarked however, that apart from throughput, also critical dimension influences the temperature stability of a target through its relation with shot noise: the smaller the desired critical dimension, the larger the dose.

Precise positioning of patterns, e.g. within a prescribed range, is of significant importance given various stages in which a target is normally treated, possibly by different types of lithography apparatuses. A main solution in this respect is to remove heat from the wafer, thereby limiting expansion, at least controlling the magnitude of positioning error. Known practices of removing heat appear however to be insufficient for removing the heat that is developed in nowadays and future direct write and other litho systems, which may e.g. at maskless e-beam lithography be in the order of hundred thousands of charged particle beams per die, alternatively put per slit. Such is in particular insufficient in case throughput of the system is not to be compromised.

While various manners of removing heat have been evaluated by the applicant, the major problems associated therewith seem to be both the capacity of heat to be taken over and speediness of the transport thereof, i.e. towards a heat absorbing metal block located to the back of a wafer. The latter phenomenon is in the art known mostly referred to by the term thermal diffusivity, which thus is observed to be insufficient in many cases. In such evaluated cases, often either the heat absorbing capacity is absorbed while dimensioning of the absorbing body already is problematic, or the transfer of heat is so slow that the level of heat at the target remains unacceptably high. As to capacity of heat to be absorbed it is remarked that metals like copper, though showing a superb diffusivity, cannot be applied given the volume required for absorbing heat induced at the target. Also other examples of removing heat such as using cooling water appear to be inappropriate for many nowadays and forthcoming types of lithography systems. It is thus an object of the invention to provide for a compact means of transporting and absorbing heat from a wafer, i.e. operable in vacuum, preferably at room temperature.

### Background

Known solutions in the art comprise anticipation of heat expansion by means of software control of the pattern to be projected, as is e.g. provided by patent publication US2002/0147507. The latter document teaches the use of an adaptive, Kalman filter to control electron beam placement, and thereby wafer heating, possibly implemented in a real time process control. This technology however does not address the fundamental problem of temperature stability and heat removal as desired by modern lithography systems. US patent publication 2005/0186517 teaches to cause opposite stress against wafer expansion after an initial stress relieving expansion of a wafer chuck, thereby potentially doubling the amount of allowed heating of the wafer before undesired slip between wafer and chuck occurs.

In PCT/US01/26772 a wafer clamp is disclosed which is favourably used for transport of heat induced by a charged particle beam on a target. Clamping of a wafer on to a supporting structure is in this known device performed by applying "one or more" phase transitions to a clamping component that is applied between a wafer and a supporting structure, which phase transitions "facilitate various operations throughout the process" and "ensure that the wafer may be easily loaded and released from the structure. The clamping component is applied in a liquid or gaseous form, and brought into a solid state by active cooling of the support structure, so as to achieve a solid clamping of wafer to said structure. It is here concluded that such a manner of clamping can basically be denoted as gluing the wafer. The known device is indicated to be "particularly useful in processes that require wafer cooling". In particular "the clamping apparatus provides highly efficient cooling in vacuum due to the large contact area between component and wafer, and the high thermal conductivity of the clamping component". This background document is however silent to the manner of cooling relatively high inductance of heat, as may occur in modern apparatus with very high throughput in terms of wafers per hour.

EP 0 484 179 A2 describes a substrate holding device including a chuck having an attracting surface for holding a substrate, an inside space and an inside heat pipe structure provided in the inside space; a temperature controlling block with a structure allowing flow of a temperature controlling medium therethrough, the temperature controlling block being thermally related to the attracting surface of the chuck through the heat pipe structure; and a stage for moving the chuck and the temperature controlling block as a unit, and for supporting the chuck through the temperature controlling block.

US 2005/0128448 A1 describes a lithographic apparatus including an illumination system for providing a beam of radiation and a support structure for supporting a patterning device. The patterning device serves to impart the beam with a pattern in its cross-section. The apparatus also has a substrate table for holding a substrate and a projection system for projecting the patterned beam onto a target portion of the substrate. The lithographic apparatus further has a chuck for supporting an object and a frame which supports the chuck with respect to other parts of the lithographic apparatus. The chuck is thermally isolated from at least the frame.

### Summary of the Invention

The present invention provides a solution to the problem of heat transfer as described earlier, i.e. within a limited amount of space, with relatively high capacity and swift transfer of heat, without unduly complicating the process of loading or locating a target to be cooled within the stage of a direct write lithography machine.

In this respect the invention, as defined by the appended claims, is characterised in that energy that is accumulated in a target by the projection of said image or image pattern is removed from said target in such a manner that expansion by local and overall heating of said target is limited to a relevant pre-defined value, wherein such heat removal is realised by the use of a phase transition in a heat absorbing material that is brought into thermal contact with said target.

It is thus understood by the invention that a phase transition in itself may be effectively used for absorbing heat from a lithography target. In a phase transition, to a lesser or larger extent, the temperature of the material in transition remains at least virtually constant, i.e. varies with a relatively much less extent than outside said phase transition, with sustained application of heat to said material. Surprisingly, by using this phenomenon for the purpose of heat removal, a very compact and sophisticated manner of cooling a lithography target is achieved. It was found however, as an aspect underlying the invention, that materials providing superior capability of heat absorption without undue raise of temperature during such phase transition, could suffer from strongly limited thermal diffusivity, especially in a layer that had in mean time undergone the phase transition, the effect being that that overall thermal diffusivity of the material body is determined by said first transited layer. It is therefore a further aspect of the invention that such material of superior heat absorbing capacity is combined with a further material having a relatively superior coefficient of heat transport.

In first embodiment of the latter aspect of the invention the combined material is mixed with the first material in a solution, most preferably in an emulsion. In a further presently preferred embodiment, the combined material is a honeycomb-like structure, preferably entirely enclosing the heat absorbing material. According to yet a further aspect of the invention, the two embodiments are combined. Such heat conducting material may e.g. be a metal, e.g. in the form of metal particles in case of a solution.

According to yet a further aspect of the invention, said phase transition should preferably take place at a temperature corresponding to the operational temperature of the lithography machine already improved in accordance with the invention, thereby also enhancing handling and functional aspects related to the overall operation of the machine. In a more particular embodiment such phase transition is to take place at a temperature around room temperature. So as to meet all of these above requirements, according to the invention, hexadecane is currently used as a heat absorbing material.

In applying hexadecane or any other liquid heat absorbing material, because of the use of said phase transition, only a very limited amount of material is required for absorbing heat induced by the majority of types of lithography machines. The material may therefore in principle simply be adhered to the backside of e.g. a wafer, where a layer of very limited thickness may suffice for heat absorption without undue raise in temperature.

The reason for the at first sight highly surprising choice for a material like hexadecane - due to ultimately bad conductance of heat (0,144 W/m.K for hexadecane as opposed to 140 for silicon) - has in fact been explained in the preceding: the invention teaches that a badly heat conducting materials like hexadecane can favourably be used as a heat absorbing material if these are used in and around a phase transition condition and if these are combined with a surface enlarging structure embodied in a very well heat conducting material.

In accordance with yet a further aspect of the invention the heat absorbing material is included in the litho machine in a porous structure, typically composed of the earlier mentioned heat conducting material. In such case the structure is brought into thermal contact with the target, e.g. a wafer. The invention in principle however also relates to a target such as a wafer of which the backside is provided porous, e.g. by bore holes, e.g. realised using etching techniques. In this manner, contacting surface is strongly increased without the need of an intermediate conducting material.

### Drawings

The invention will be further elucidated by way of example in the following embodiments of a mask-less lithography system according to the current invention, in which:
Figure 1 schematically illustrates a lithography target, here as a top view of a wafer, and the effect thereon caused by induced heating;
Figure 2A and 2B represent a temperature characteristic of a phase transition of a material, which is favourably used in the invention; Figure 3 represents a first embodiment of a relevant part of a lithography system, adapted for favourably removing heat from a lithography target.
Figure 4 is alike figure 3, a schematic representation however of a second embodiment of the invention in which in this case fluid heat absorbing material is included in a framed structure that is brought into contact with the target. Figure 5 is a schematic top view representation of the structure of figure 4, with an exploded view of part thereof, showing the internal grid structure.
Figure 6 is a schematic representation of a wafer and a supported by chuck as may be applied according to the invention;
Figure 7 schematically illustrates a workout of the principle illustrated along figures 4 and 5;

In the figures, corresponding structural features, i.e. at least functionally corresponding, are referred to by identical reference numbers.

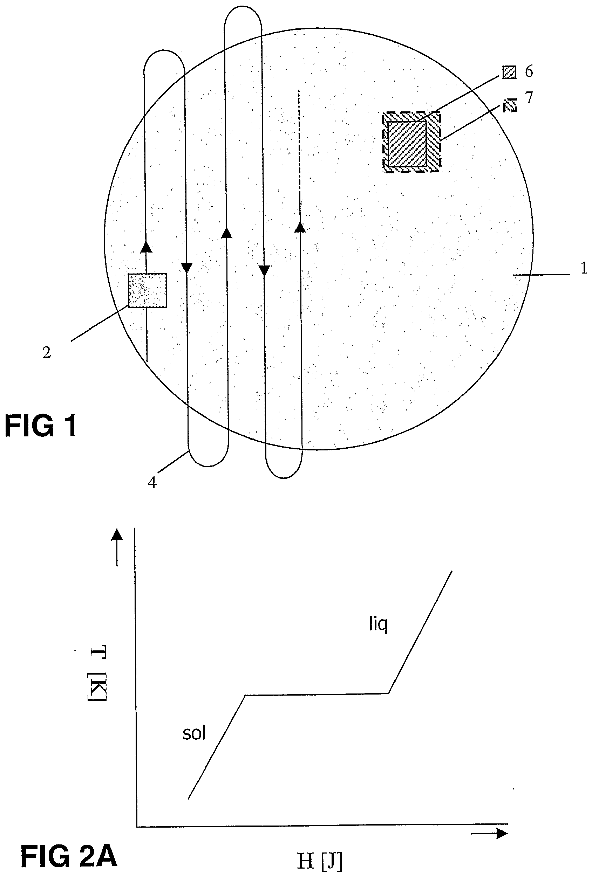

Figure 1 shows a target, here in the form of a wafer 1, which moves relative to e.g. a charged particle beam column of a litho apparatus, or other kind of beam source for lithography, according to path 4, here indicating the centre of a lens assembly or slit 2, passing over several fields 6 of the wafer.

Due to induced heat to the wafer, by the incidence of said charged particle beams - the wafer will expand. This expansion results in a difference between the expected position and dimension of a die 6 and the actual position and dimension of a die 7. This difference will result in an overlay error of the exposure pattern on the wafer.

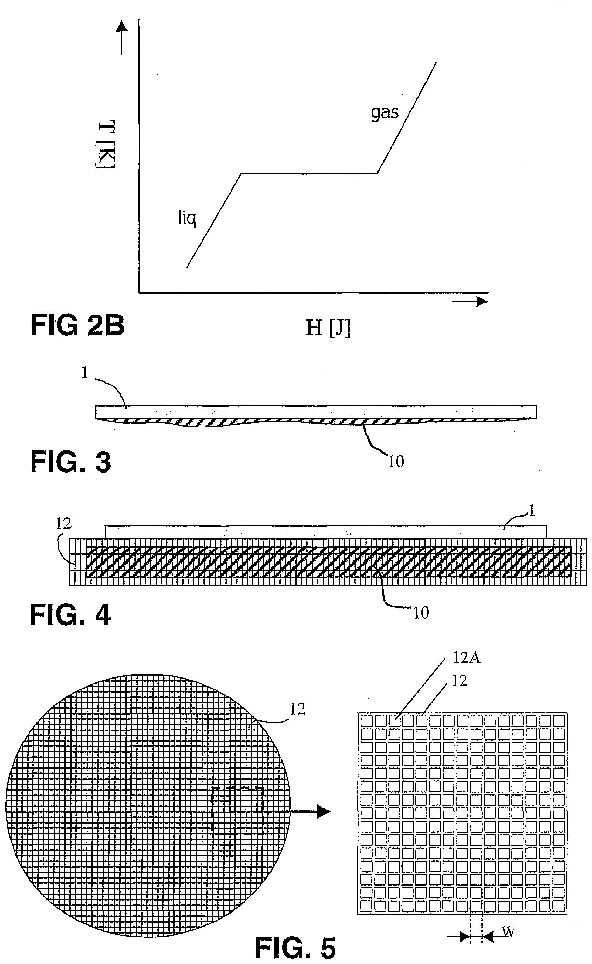

In accordance now with the present invention, heat removal from said wafer is realized by the use of a phase transition in a material - here also denoted as phase change material - that is brought into thermal contact with said target 1, e.g. as illustrated by any of the embodiments of figure 4.

Figure 2 illustrates the principle of such phase transition, in figure 2A by the transition of a heat absorbing means from solid state Sol to liquid state Liq, which is used in the present invention, and in figure 2B by the transition from liquid state Liq to gaseous state Gas: In both figures the temperature T of the absorbing means is set out (in degrees Kelvin) against the heat H (in Joules) induced by an impinging charged particle beam. It can be seen that during the transition from solid phase to liquid, or from liquid to gas, the temperature T does in principle not, and in practice only at a rather low rate, increase with increase of amount of heat H. The above described effect of figure 2A is according to the invention favorably used in the practice for transport and accumulation of heat from a target to the absorbing means. A superior coefficient of heat transport is desired between target and heat absorber. Complementary to the above, a material having preferably both a large coefficient of heat transport and a transition phase temperature near environmental temperature of the target in said lithography apparatus is applied. Most preferably is a phase transition temperature near room temperature.

Further requirements to the heat absorber are according to the invention features like non-toxiness and ability to withstand the vacuum in which it is to operate, and CMOS compatibility.

In the above respects it was found that not many materials if any, provide the combination of features desired in the present application in full. The invention, therefore proposes as a good and preferred material for application as a heat absorber, an emulsion comprising particles with a relatively high coefficient of heat transport such as metal or silicon. Such a material is relatively easily adhered to the bottom side of a target by adhesive force, and requires only a limited amount of space. In this respect a layer of several micrometers suffices. A preferred emulsion material is hexadecane. However, also glycerol (C₃H₈O₃; also well known as glycerin and glycerine, and less commonly as propane- 1,2,3-triol, 1,2,3-propanetriol, 1,2,3-trihydroxypropane, glyceritol, glycyl alcohol, citifluor AF 2; grocolene) may be applied, in particular in enclosed form as will be illustrated hereafter. The invention addresses a finding that with a phase transition the heat transfer capacity of the heat absorbing material decreases to a minimum value. Such implies than only very thin layers of the phase change or heat absorbing material can be used. To overcome this problem the same heat absorbing material is still used, however in combination with a surface increasing measure.

Figure 3 illustrates a first embodiment according to the invention, demonstrating a straight forward manner of putting the invented principle into practice. In the figure reference 1 is a cross section of a target in the form of a wafer, while 10 denotes an emulsion satisfying the needs defined in accordance with the invention.

Figure 4 illustrates another embodiment, showing a porous carrier for said target and carrying the heat absorber in its pores. In this manner a large contacting area between heat absorber and target is created by means of said intermediate carrier.

A preference exists for a porous type of carrier, e.g. as in figure 4, on the basis of an idea that the coefficient of heat transport for an emulsion is strongly reduced once it is turned from solid state into fluid state. By means of a porous carrier, which may be either the target itself or a separate frame as in figure 4, heat by-passes heat absorbent that has fluidised in the upper zones thereof, thus guaranteeing an increased transfer of heat at any instant within the process of phase transition. In fact it may be stated that the carrier has an improved thermal conductance relative to a fluidised part of the heat absorbent. With a suitable heat conducting material such as metal or silicon, i.e. a wafer material, a homogeneous heating of the entire frame will in practice easily be achieved, thereby assuring that the heat absorbing material is contacted adequately over a highly enlarged surface area. The square holes or bores may be achieved by etching, and are in the present example of a dimension of 50 by 50 µm or smaller, with wall thicknesses of 5 µm or smaller.

Figure 5 provides sectional views of a possible hexadecane frame as illustrated by figure 4. The left side figure part is an overall view of e.g. a wafer like structure, while the right side figure part illustrates a section as could be applicable to the size of a die in a wafer. In this example, in a die of 26 by 33 mm the number of square bores would thus be (26 * 33 mm) / (50+5 µm)^2 = 283,640. The goal of the frame is to increase the usable area of the PCM. According to Newton's law of conduction, Q=((k*A/1)*dT, the required temperature difference dT to transport a given amount of heat Q over a distance 1, reduces with increasing surface A. By etching holes 12A in the bottom of the wafer 12, with a depth h, the usable surface per area W*W is increased to h*4*W for the shown geometry. Corresponding calculations also apply to a preferred frame with at least predominantly rectangular bores as taken in cross section. Such is embodied with the sort side of such shape considerably smaller in width than the width of the walls shaping said rectangular structure, preferably with a ratio within the range of 5 to 15, preferably around 10, thus e.g. bores or openings of a size of 50 by 5 micrometer, without these examples limiting the principle of increasing surface area by means of relatively long stretched openings. The degree of possible filling said structure with heat absorbing means is thereby increased, and preferably set to a value within the range of 60% to 90% surface area, e.g. around 75%.

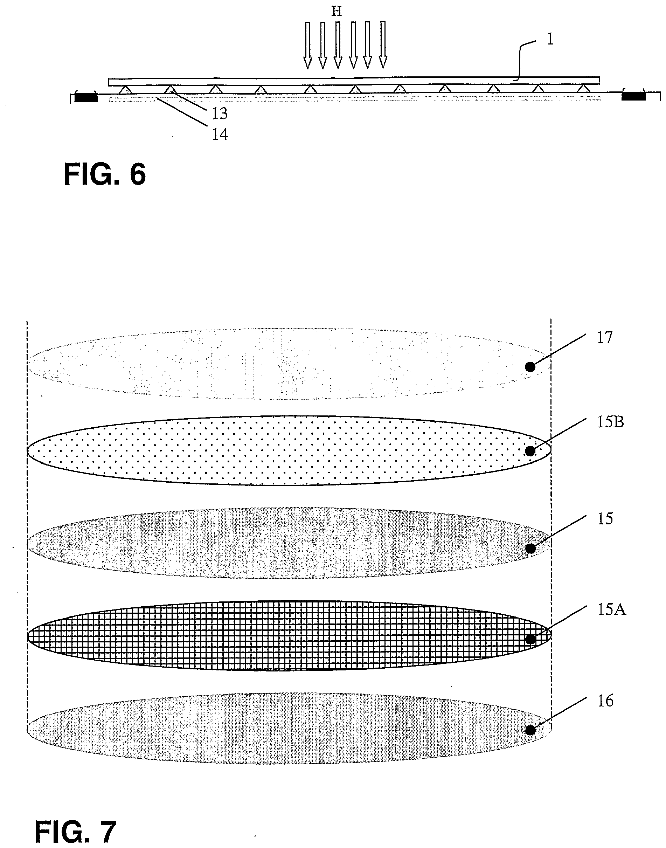

Figure 6 provides a schematic representation of a wafer and a wafer chuck as may for example be applied in accordance with the invention. To reduce the influence of backside particle contamination on the wafer, the wafer is placed on burls 13. By applying burls 13, the chance that a particle will be present between the wafer 1 and a burl 13 is minimised. To minimize focus errors because of wafer un-flatness, the wafer 1 is attracted on a very flat table made out of said burls. An electrostatic clamp 14 is applied in this respect, favourably meeting the vacuum condition of a stage. Other known or new type of clamps may in principle be applied as well however, an example of which is provided in the following.

Typical values for applied attractive force are around 0.1 Bar or lower, depending on the applied manner of attraction. The dielectric properties of the material between wafer and clamp determine the achievable attractive force between wafer and clamp. The maximum allowable clamp voltage is limited by the breakthrough voltage and also depends on material and manufacturing process. Of course other manners of clamping may also be applied, without diminishing the significance of the present invention. With the presently proposed manner of clamping, for further optimisation, a fluid could be provided between the burled layer and the target, however strongly differing from the heat absorbing material, due to a desired function of improving heat conductance. In this respect the occurrence of a phase transition would for this material be highly undesired.

It was recognised that heat may in the current practice not conduct far in x and y direction, so that the number of burls is considerably increased compared to present common practice. The burls are preferably produced significantly smaller than conventional electrostatic clamping burls. Also, the total area of the burls is made significantly larger than conventional, i.e. with a function in clamping alone, or at least than without such added function of conduction of heat. In this respect the total contacting surface between target and burl is within the range of 1 to 5% of the total target surface, preferably around 1%. The latter and the increased number of burls implies an increased though accepted risk of particles trapped in between burls and wafer, distorting the flatness of the latter.
Figure 7 schematically illustrates one possible embodiment of the principle illustrated along figure 4 and 5, in which the heat conducting frame is constituted by a wafer having an upper side 15, which is etched to the effect that burls 15B are created, in casu approximately 1 micron high burls. The opposite side 15A of the wafer is etched to the effect that bores are created for holding the heat absorbing material. The bottom layer 16 represented in figure 7 represents a frame closing layer attached to the bottom of the first layer and is here embodied by a second wafer. In this manner the heat absorbing material is shielded from the vacuum in which it is as in this example, very often to function. The top layer 17 present on the frame represented in figure 7, is a thermally conducting, electrically insulating layer. Such layer is applied, e.g. by sputtering, onto the surface burls including surface. In this case X micron Aluminium nitride (AIN) material is used, but such could in accordance with the invention also e.g. be Beryllium Oxide (BeO). In this manner figure 7 illustrates a relatively advantageous manner of putting the principle illustrated along figure 4 into practice. The closing plate 16 serves to keep the phase change material in the etched frame, prevents out gassing in a vacuum environment, provides strength to the structure and serves as a flat reference plane.
Apart from the concepts and all pertaining details as described in the preceding, the invention relates to all features as defined in the following set of claims. In the following set of claims, rather than fixating the meaning of a preceding term, any reference numbers corresponding to structures in the figures are, for reason of support at reading the claim, included solely for indicating an exemplary meaning of a preceding term and are for that reason included between brackets.

## Claims

1. A lithography system for projecting an image or an image pattern on to a target such as a wafer,
wherein energy that is accumulated in the target by the projection of the image or image pattern is removed from said target in such a manner that expansion by local and/or overall heating of said target is limited to a relevant pre-defined value, and
wherein such heat removal is realized by the use of a phase transition from solid to liquid in a heat absorbing material that is brought into thermal contact with said target by means of a surface enlarging body, wherein said body is a circular body and comprises a framed structure containing said heat absorbing material, which framed structure is brought into contact with said target, and
wherein said body is further provided with a frame closing layer (16) arranged on a side of said body opposite from a target facing side.

2. System according to claim 1, wherein said framed structure has an internal grid structure comprising multiple bores or openings for holding the heat absorbing material.

3. System according to claim 2, wherein said multiple bores or openings have an at least predominantly rectangularly shaped cross section.

4. System according to claim 3, wherein a short side of the rectangularly shaped cross-section of the bores or openings is considerably smaller in width than the width of the walls shaping said rectangular bores or openings, with a ratio within the range of 5 to 15.

5. System according to claim 2, 3 or 4, wherein the degree of filling of said grid structure with said heat absorbing material is set to a value within the range of 60%-90% surface area of said bores or openings.

6. System according to any one of the claims 2-5, wherein said bores or openings are achieved by etching.

7. System according to any one of claims 2, 3, 5 or 6, wherein said openings or bores have a dimension of 50 by 50 micron or smaller, with wall thicknesses of 5 micron or smaller.

8. System according to any one of the preceding claims, wherein the contacting surface of the phase transition material is substantially larger than a surface to be processed of said target.

9. System according to any one of the preceding claims, wherein said heat absorbing material has a phase transition from the solid state to the liquid state at a temperature corresponding to that of the operational temperature of said lithography system.

10. System according to claim 1, wherein said body comprises a top layer (17), said frame closing layer (16), and said internal frame (15A) connecting said top layer and said frame closing layer.

11. System according to any one of the preceding claims, wherein said body is an internally porous body.

12. Method of stabilizing a target temperature in a lithography system according to any one of the preceding claims, by removing heat from the target using a phase transition from solid state to liquid state in said heat absorbing material that is brought into thermal contact with said target.

## Patentansprüche

1. Ein Lithographiesystem zum Projizieren eines Bildes oder eines Bildmusters auf ein Objekt, wie etwa einen Wafer,
wobei Energie, die in dem Objekt durch die Projektion des Bildes oder Bildmusters angesammelt wird, von dem Objekt auf solche eine Weise abgeleitet wird, dass eine Ausdehnung durch lokales Erwärmen und/oder Gesamterwärmen des Objekts auf einen relevanten vordefinierten Wert begrenzt wird, und
wobei eine solche Wärmeableitung durch die Anwendung eines Phasenübergangs von fest zu flüssig in einem wärmeabsorbierenden Material, das mittels eines oberflächenvergrößernden Körpers in thermischen Kontakt mit dem Objekt gebracht wird, wobei der Körper ein runder Körper ist und eine Rahmenstruktur, enthaltend das wärmeabsorbierende Material, umfasst, wobei die Rahmenstruktur in Kontakt mit dem Objekt gebracht wird, erfolgt und
wobei der Körper des weiteren mit einer rahmenschließenden Schicht (16), angeordnet auf einer Seite des Körpers, die einer zum Objekt zeigenden Seite gegenüberliegt, angeordnet ist.

2. System gemäß Anspruch 1, wobei die Rahmenstruktur eine innere Gitterstruktur umfassend mehrere Löcher oder Öffnungen zum Halten des wärmeabsorbierenden Materials aufweist.

3. System gemäß Anspruch 2, wobei die mehreren Löcher oder Öffnungen einen wenigstens überwiegend rechteckförmigen Querschnitt aufweisen.

4. System gemäß Anspruch 3, wobei eine kurze Seite des rechteckförmigen Querschnitts der Löcher oder Öffnungen deutlich geringer in der Breite als die Weite der Wandungen, welche die rechteckigen Löcher oder Öffnungen bilden, mit einem Verhältnis im Bereich von 5 bis 15 ist.

5. System gemäß einem der Ansprüche 2, 3 oder 4, wobei der Grad der Füllung der Gitterstruktur mit dem wärmeabsorbierenden Material bei einem Wert im Bereich von 60 bis 90% der Oberfläche der Löcher oder Öffnungen liegt.

6. System gemäß einem der Ansprüche 2 bis 5, wobei die Löcher oder Öffnungen durch Ätzen erzeugt werden.

7. System gemäß einem der Ansprüche 2, 3, 5 oder 6, wobei die Öffnungen oder Löcher eine Abmessung von 50 x 50 µm oder weniger mit Wandungsdicken von 5 Mikrometer oder weniger aufweisen.

8. System gemäß einem der vorhergehenden Ansprüche, wobei die Kontaktoberfläche des Phasenübergangsmaterials deutlich größer als eine zu bearbeitende Oberfläche des Objekts ist.

9. System gemäß einem der vorhergehenden Ansprüche, wobei das wärmeabsorbierende Material einen Phasenübergang von dem festen Zustand zu dem flüssigen Zustand bei einer Temperatur, die der Betriebstemperatur des Lithographiesystems entspricht, aufweist.

10. System gemäß Anspruch 1, wobei der Körper eine obere Schicht (17), die rahmenschließende Schicht (16) und den inneren Rahmen (15A), der die obere Schicht und die rahmenschließende Schicht verbindet, aufweist.

11. System gemäß einem der vorhergehenden Ansprüche, wobei der Körper ein innerlich poröser Körper ist.

12. Verfahren zum Stabilisieren einer Objekttemperatur in einem Lithographiesystem gemäß einem der vorhergehenden Ansprüche durch Ableiten von Wärme von dem Objekt unter Verwendung eines Phasenübergangs vom festen Zustand zum flüssigen Zustand, in dem wärmeabsorbierenden Material, das in thermischen Kontakt mit dem Objekt gebracht wird.

## Revendications

1. Système de lithographie pour projeter une image ou un motif d'image sur une cible telle qu'une tranche,
dans lequel l'énergie qui est accumulée dans la cible par la projection de l'image ou du motif d'image est supprimée de ladite cible de sorte que l'expansion par le chauffage local et/ou global de ladite cible est limitée à une valeur prédéfinie pertinente, et
dans lequel ladite suppression de chaleur est réalisée par l'utilisation d'une transition de phase solide à liquide dans un matériau absorbant la chaleur qui est amené en contact thermique avec ladite cible au moyen d'un corps d'agrandissement de surface, dans lequel ledit corps est un corps circulaire et comprend une structure à cadre contenant ledit matériau absorbant la chaleur, laquelle structure à cadre est amenée en contact avec ladite cible, et
dans lequel ledit corps est en outre pourvu d'une couche de fermeture de cadre (16) agencée sur un côté dudit corps à l'opposé d'un côté orienté vers la cible.

2. Système selon la revendication 1, dans lequel ladite structure à cadre a une structure de grille interne comprenant de multiples alésages ou ouvertures pour maintenir le matériau absorbant la chaleur.

3. Système selon la revendication 2, dans lequel lesdits multiples alésages ou ouvertures ont une coupe de forme au moins principalement rectangulaire.

4. Système selon la revendication 3, dans lequel un côté court de la coupe de forme rectangulaire des alésages ou ouvertures a une largeur considérablement plus petite que la largeur des parois formant lesdits alésages ou ouvertures rectangulaires, avec un rapport dans la plage de 5 à 15.

5. Système selon l'une quelconque des revendications 2, 3 ou 4, dans lequel le degré de remplissage de ladite structure de grille avec ledit matériau absorbant la chaleur est fixé à une valeur à l'intérieur de la plage de 60 % à 90 % de superficie desdits alésages ou ouvertures.

6. Système selon l'une quelconque des revendications 2 à 5, dans lequel lesdits alésages ou ouvertures sont obtenus par décapage.

7. Système selon l'une quelconque des revendications 2, 3, 5 et 6, dans lequel lesdits ouvertures ou alésages ont une dimension de 50 par 50 microns ou moins, avec des épaisseurs de paroi de 5 microns ou moins.

8. Système selon l'une quelconque des revendications précédentes, dans lequel la surface de contact du matériau de transition de phase est sensiblement plus grande qu'une surface à traiter de ladite cible.

9. Système selon l'une quelconque des revendications précédentes, dans lequel ledit matériau absorbant la chaleur a une transition de phase de l'état solide à l'état liquide à une température correspondant à celle de la température fonctionnelle dudit système de lithographie.

10. Système selon la revendication 1, dans lequel ledit corps comprend une couche supérieure (17), ladite couche de fermeture de cadre (16), et ledit cadre interne (15A) reliant ladite couche supérieure et ladite couche de fermeture de cadre.

11. Système selon l'une quelconque des revendications précédentes, dans lequel ledit corps est un corps poreux intérieurement.

12. Procédé de stabilisation d'une température cible dans un système de lithographie selon l'une quelconque des revendications précédentes, par la suppression de la chaleur de la cible en utilisant une transition de phase de l'état solide à l'état liquide dans dit matériau absorbant la chaleur qui est amené en contact thermique avec ladite cible.
